# EUROPEAN PATENT SPECIFICATION

(11) **EP 1 729 176 B1**
(45) Date of publication and mention of the grant of the patent: **28.06.2017**
(21) Application number: 05721412.4
(22) Date of filing: 24.03.2005
(51) Int. Cl.: G03F 7/039, C08F 220/58, G03F 7/033, G03F 7/20, H01L 21/027, H01L 21/60

(54) **POSITIVE RADIATION-SENSITIVE RESIN COMPOSITION**
POSITIV ARBEITENDE STRAHLUNGSEMPFINDLICHE HARZZUSAMMENSETZUNG
COMPOSITION DE RÉSINE POSITIVE SENSIBLE AU RAYONNEMENT

(30) Priority: 24.03.2004 JP 2004087520
(43) Date of publication of application: 06.12.2006
(73) Proprietor: JSR Corporation, Tokyo 105-8640 (JP)
(72) Inventor: NISHIKAWA, Kouji, Tokyo 105-8640 (JP); IWANAGA, Shin-ichiro, Tokyo 105-8640 (JP)
(74) Representative: TBK
(86) International application number: PCT/JP2005/005398
(87) International publication number: WO 2005/091074

(56) References cited:
- WO-A-92/15549
- JP-A- 2000 122 283
- JP-A- 2001 281 863
- JP-A- 2004 029 437
- US-A- 5 326 840
- US-A1- 2004 038 148

## Description

### TECHNICAL FIELD

The present invention relates to a positive radiation-sensitive resin composition preferably used for producing a plated shaped article, a transfer film using the composition and a process for producing a plated shaped article.

### BACKGROUND ART

As integrated circuit devices have been made finer, higher integration of large scale integrated circuits (LSI) and shifting to application specific integrated circuits (ASIC) have been rapidly promoted recently. On that account, a multi-pin thin film mounting process for mounting LSI on electronic equipment is required, and bare chip mounting by a tape automated bonding (TAB) system or a flip chip system has been adopted. In such a multi-pin thin film mounting process, a protruded electrode having a height of not less than 10 µm that is called a bump needs to be arranged as a connecting terminal on a substrate with high precision.

Such a bump is produced by the following process at present. First, a barrier metal that becomes an electrically conductive layer is laminated on a wafer that has been worked as a LSI device, and then a radiation-sensitive resin composition, i.e., so-called a resist, is applied and dried. Subsequently, the resist is irradiated with radiation (referred to as "exposure" hereinafter) through a mask so as to form an opening corresponding to the place where a bump is to be formed, and then the resist is developed to form a pattern. Thereafter, using the pattern as a mold, electroplating is performed to deposit an electrode material such as gold or copper. Then, the resin portion is stripped, and the barrier metal is removed by etching. Thereafter, a square chip is cut out from the wafer, followed by a mounting process, such as packaging (e.g., TAB) or a flip chip system.

In a series of steps of the above process for producing a bump, the following properties are required for the resist.
(1) The resist can form a coating film having a uniform thickness of not less than 20 µm.
(2) In order to cope with narrowing of a pitch between bumps, the resist exhibits high resolution.
(3) The pattern that becomes a mold has an almost perpendicular sidewall, and the pattern has fidelity to the mask dimension.
(4) In order to enhance production efficiency of the process, the resist has high sensitivity and excellent developability.
(5) The resist exhibits excellent wettability by a plating solution.
(6) The resist component is not eluted into a plating solution in the plating step, so that it does not deteriorate the plating solution.
(7) The resist has high adhesion to a substrate so that the plating solution should not be introduced into the interface between the substrate and the resist in the plating step.
(8) After plating, the resist can be easily stripped by a stripping solution.
   Moreover, the resulting deposit needs to have the following properties.
(9) To the deposit, the shape of the pattern that is a mold has been transferred with fidelity, and the deposit has fidelity to the mask dimension.

As the resist for forming a bump, a positive radiation-sensitive resin composition containing a novolak resin and a naphthoquinonediazide group-containing compound as main components has been heretofore employed (see, e.g., patent document 1). In this case, however, there is a problem that even if a resist composed of the composition is developed, the resulting pattern is in such an inclined shape (tapered shape) that the pattern is tapered off to the resist surface from the substrate surface, and a pattern having a perpendicular sidewall is not obtained. Further, there is another problem that because of low sensitivity of the resist, the exposure time is prolonged and the production efficiency is low. Furthermore, it cannot be said that the composition is satisfactory in the resolution and the fidelity of a deposit of a large thickness to the mask dimension.
Patent document 1: Japanese Patent Laid-Open Publication No. 207067/1998

### DISCLOSURE OF THE INVENTION

### PROBLEM TO BE SOLVED BY THE INVENTION

It is an object of the present invention to provide a production process capable of precisely producing a plated shaped article of a large thickness such as a bump or a wiring, a positive radiation-sensitive resin composition which is preferably used for the process and has excellent sensitivity and resolution, and a transfer film using the composition. This object is achieved by the subject-matters of claims 1, 10 and 12. Preferable embodiments are defined in claims 2-9 and 11.

### MEANS TO SOLVE THE PROBLEM

The positive radiation-sensitive resin composition according to the present invention comprises:
(A) a polymer containing structural units (a) represented by the following formula (1), an acid-dissociable functional group (b), and structural units obtained by aromatic vinyl compounds, 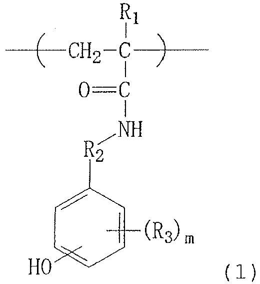 wherein R₁ is a hydrogen atom or a methyl group, R₂ is - (CH₂)ₙ-, n is an integer of 0 to 3, R₃ is an alkyl group of 1 to 4 carbon atoms, and m is an integer of 0 to 4,
(B) a component which generates an acid by irradiation with radiation, and
(C) an organic solvent.

The acid-dissociable functional group (b) is preferably represented by the following formula (3): 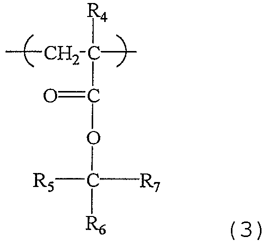 wherein R₄ is a hydrogen atom or a methyl group, R₅ to R₇ are each an alkyl group of 1 to 4 carbon atoms, an alicyclic hydrocarbon group of 4 to 20 carbon atoms, an aromatic group or a substituted hydrocarbon group wherein at least one hydrogen atom in any one of these hydrocarbon groups is replaced with a polar group other than a hydrocarbon group, R₅ to R₇ may be the same or different, and when any two of R₅ to R₇ are alkyl groups or substituted alkyl groups, their alkyl chains may be bonded to each other to form an alicyclic hydrocarbon group of 4 to 20 carbon atoms or a substituted alicyclic hydrocarbon group.

The composition of the invention is preferably used for producing a plated shaped article, particularly a bump.

In the composition of the invention, the component (B) is preferably contained in an amount of 0.1 to 20 parts by weight based on 100 parts by weight of the component (A), and the component (C) is preferably contained in an amount of 20 to 80 parts by weight based on the total weight 100 parts by weight of the positive radiation-sensitive resin composition.

When a resin film having a film thickness of not less than 50 µm is formed from the resin composition, an acid dissociation product obtained by dissociation of the acid-dissociable functional group (b) by the use of an acid preferably has a boiling point at 1 atm of not lower than 20°C.

The positive radiation-sensitive resin composition of the invention may further comprise an alkali-soluble resin other than the polymer (A). The composition may further comprise an acid diffusion controller.

The transfer film according to the present invention has a resin film composed of the above-mentioned resin composition. The resin film preferably has a film thickness of 20 to 200 µm.

The process for producing a plated shaped article according to the present invention comprises:
(1) a step of forming a resin film composed of the positive radiation-sensitive resin composition on a wafer having a barrier metal layer,
(2) a step of exposing the resin film and then developing the resin film to form a pattern,
(3) a step of depositing an electrode material by electroplating using the pattern as a mold, and
(4) a step of stripping the remaining resin film and then removing the barrier metal by etching.

### EFFECT OF THE INVENTION

By the use of the positive radiation-sensitive composition of the invention, a pattern that becomes a mold for electroplating can be formed with fidelity to the mask dimension. Further, to the composition, the shape of a pattern that becomes a mold can be accurately transferred even in the electroplating step, and the composition can form a plated shaped article having fidelity to the mask dimension and has excellent sensitivity and resolution. Accordingly, the positive radiation-sensitive composition of the invention can be extremely preferably used for producing a plated shaped article of a large thickness such as a bump or a wiring of an integrated circuit device. In particular, the positive radiation-sensitive resin composition having a structural unit represented by the chemical formula (1) exhibits excellent resolution performance on a copper sputtered substrate.

### BEST MODE FOR CARRYING OUT THE INVENTION

The positive radiation-sensitive resin composition of the invention comprises (A) a polymer containing a specific structural unit (a) and an acid-dissociable functional group (b) which is dissociated by an acid and becomes acidic, (B) a component which generates an acid by irradiation with radiation and (C) an organic solvent.

The positive radiation-sensitive resin composition of the invention contains a component which generates an acid upon exposure (referred to as an "acid generator" hereinafter). When an acid is generated by exposure, chemical reaction (e.g., change of polarity, decomposition of chemical bonding, or the like) takes place in a resin film (i.e., resist film) composed of the positive radiation-sensitive resin composition by virtue of a catalytic action of the acid, and the solubility of the resist in a developing solution is changed in the exposed portion. By making the best use of this phenomenon, the positive radiation-sensitive resin composition of the invention forms a pattern that becomes a mold for electroplating.

The mechanism of the pattern formation is further described below. When an acid generator is exposed, an acid is generated. By virtue of a catalytic action of the acid, the acid-dissociable functional group contained in the positive radiation-sensitive resin composition undergoes reaction, and thereby, it not only becomes an acidic functional group but also forms an acid dissociation product. As a result, solubility of the exposed polymer portion in an alkali developing solution is increased. The reaction of the acid-dissociable functional group is accelerated by carrying out heating (i.e., post exposure bake, referred to as "PEB" hereinafter) after exposure. The acid newly generated by the reaction of the acid-dissociable functional group acts as a catalyst on the reaction of another acid-dissociable functional group, whereby reaction of an acid-dissociable functional group and generation of an acid are "amplified" one after another. By making the best use of such a chemical amplification action, a given pattern is formed with high sensitivity (i.e., small quantity of light for exposure) and high resolution.

The alkali developing solution used for developing the exposed resist film can be prepared by dissolving one or more kinds of alkaline compounds in water or the like. After the development using the alkali developing solution, washing with water is usually carried out.

### Polymer (A)

The polymer (A) for use in the invention is a polymer comprising the below-described structural units (a) represented by the following formula (1) and an acid-dissociable functional group (b). 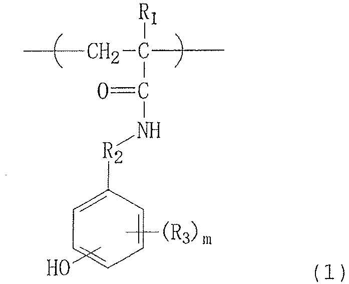 The polymer (A) may further contain a structural unit represented by the following formula (2): 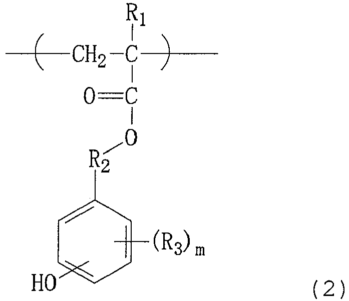 wherein R₁ is a hydrogen atom or a methyl group, R₂ is - (CH₂)ₙ-, n is an integer of 0 to 3, R₃ is an alkyl group of 1 to 4 carbon atoms, and m is an integer of 0 to 4.

Because the structural units represented by the formula (1) and/or the formula (2) are contained in the polymer (A), an effect of increasing adhesion of the resist to a substrate and thereby preventing introduction of a plating solution into the interface between the substrate and the resist in the plating step is exerted. Further, by controlling the type and the number of substituents contained in the structural unit, degree of acidity of the phenolic hydroxyl group can be changed, and hence, solubility of the composition of the invention in an alkali developing solution can be controlled.

### Monomer (1') and monomer (2')

The structure of the formula (1) can be obtained by polymerizing a monomer (1') represented by the following formula to form the polymer (A). The structure of the formula (2) can be obtained by polymerizing a monomer (2') represented by the following formula to form the polymer (A).

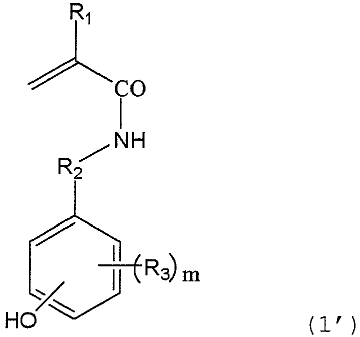

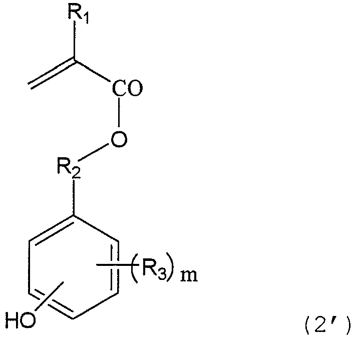

In the above formulas, R₁ is a hydrogen atom or a methyl group, R₂ is -(CH₂)ₙ-, n is an integer of 0 to 3, R₃ is an alkyl group of 1 to 4 carbon atoms, and m is an integer of 0 to 4.

Examples of the monomers (1') include amide group-containing vinyl compounds, such as p-hydroxyphenyl acrylamide, p-hydroxyphenyl methacrylamide, o-hydroxyphenyl acrylamide, o-hydroxyphenyl methacrylamide, m-hydroxyphenyl acrylamide, m-hydroxyphenyl methacrylamide, p-hydroxybenzyl acrylamide, p-hydroxybenzyl methacrylamide, 3,5-dimethyl-4-hydroxybenzyl acrylamide, 3,5-dimethyl-4-hydroxybenzyl methacrylamide, 3,5-tert-butyl-4-hydroxybenzyl acrylamide, 3,5-tert-butyl-4-hydroxybenzyl methacrylamide, o-hydroxybenzyl acrylamide and o-hydroxybenzyl methacrylamide.

Examples of the monomers (2') include (meth)acrylic esters, such as p-hydroxyphenyl (meth)acrylate, o-hydroxyphenyl (meth)acrylate, m-hydroxyphenyl (meth)acrylate, p-hydroxybenzyl (meth)acrylate, 3,5-dimethyl-4-hydroxybenzyl (meth)acrylate, 3,5-tert-butyl-4-hydroxybenzyl (meth)acrylate and o-hydroxybenzyl (meth)acrylate.

Of the above monomers (1') and (2'), preferable are p-hydroxyphenyl acrylamide, p-hydroxyphenyl methacrylamide, 3,5-dimethyl-4-hydroxybenzyl acrylamide, 3,5-dimethyl-4-hydroxybenzyl methacrylamide, p-hydroxyphenyl methacrylate and p-hydroxybenzyl methacrylate.

The monomers (1') or the monomers (2') can be used singly or as a mixture of two or more kinds. Further, the monomer (1') and the monomer (2') may be used in combination.

### Acid-dissociable functional group (b)

The acid-dissociable functional group (b) contained in the polymer (A) is not specifically restricted as long as it is dissociated by an acid to form an acidic functional group. The acid-dissociable functional group (b) is, for example, a functional group that is dissociated by an acid to form a carboxyl group or a functional group that is dissociated by an acid to form a phenolic hydroxyl group.

Of such acid-dissociable functional groups (b), preferable is a functional group represented by the following formula (3): 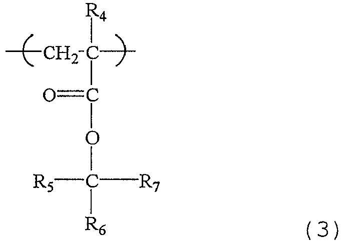 wherein R₄ is a hydrogen atom or a methyl group, R₅ to R₇ are each an alkyl group of 1 to 4 carbon atoms, an alicyclic hydrocarbon group of 4 to 20 carbon atoms, an aromatic group or a substituted hydrocarbon group wherein at least one hydrogen atom in any one of these hydrocarbon groups is replaced with a polar group other than a hydrocarbon group, R₅ to R₇ may be the same or different, and when any two of R₅ to R₇ are alkyl groups or substituted alkyl groups, their alkyl chains may be bonded to each other to form an alicyclic hydrocarbon group of 4 to 20 carbon atoms or a substituted alicyclic hydrocarbon group.

### Monomer (I)

The polymer having such an acid-dissociable functional group (b) can be obtained by, for example, polymerizing a monomer (I) having an acid-dissociable functional group. For example, the structure of the formula (3) can be obtained by polymerizing a monomer (3') represented by the following formula to form the polymer (A).

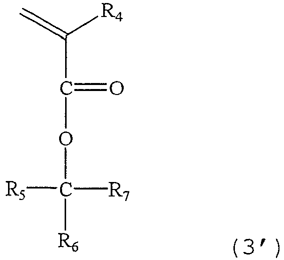

In the above formula, R₄ is a hydrogen atom or a methyl group, R₅ to R₇ are each an alkyl group of 1 to 4 carbon atoms, an alicyclic hydrocarbon group of 4 to 20 carbon atoms, an aromatic group or a substituted hydrocarbon group wherein at least one hydrogen atom in any one of these hydrocarbon groups is replaced with a polar group other than a hydrocarbon group, R₅ to R₇ may be the same or different, and when any two of R₅ to R₇ are alkyl groups or substituted alkyl groups, their alkyl chains may be bonded to each other to form an alicyclic hydrocarbon group of 4 to 20 carbon atoms or a substituted alicyclic hydrocarbon group.

In the formula (3'), R₅ to R₇ are each an alkyl group of 1 to 4 carbon atoms, an alicyclic hydrocarbon group of 4 to 20 carbon atoms, an aromatic group or a substituted hydrocarbon group wherein at least one hydrogen atom in any one of these hydrocarbon groups is replaced with a polar group other than a hydrocarbon group.

Examples of the alkyl groups of 1 to 4 carbon atoms include methyl, ethyl, n-propyl, i-propyl, n-butyl, 2-methylpropyl, 1-methylpropyl and t-butyl.

Examples of the alicyclic hydrocarbon groups of 4 to 20 carbon atoms include cycloalkyl groups, such as cyclobutyl, cyclopentyl, cyclohexyl, cycloheptyl and cyclooctyl; and groups derived from bridged hydrocarbons, such as adamantane, bicyclo[2.2.1]heptane, tetracyclo [6.2.1.1^{3,6}.0^{2,7}] dodecane and tricyclo [5.2.1.0^{2,6}] decane. When any two of R₅ to R₇ are alkyl groups, their alkyl chains may be bonded to each other to form an alicyclic hydrocarbon group of 4 to 20 carbon atoms, and examples of the alicyclic hydrocarbon groups thus formed include the same alicyclic hydrocarbon groups as described above.

Examples of the aromatic groups include phenyl, o-tolyl, m-tolyl, p-tolyl, 4-t-butylphenyl, 1-naphthyl and benzyl.

Examples of the polar groups other than hydrocarbon groups in the substituted hydrocarbon group, with which a hydrogen atom can be replaced, include:
chloro group; hydroxyl group; carboxyl group; oxo group (i.e., =O group);
hydroxyalkyl groups, such as hydroxymethyl, 1-hydroxyethyl, 2-hydroxyethyl, 1-hydroxypropyl, 2-hydroxypropyl, 3-hydroxypropyl, 2-hydroxybutyl, 3-hydroxybutyl and 4-hydroxybutyl;
alkoxyl groups of 1 to 6 carbon atoms, such as methoxy, ethoxy, n-propoxy, i-propoxy, n-butoxy, 2-methylpropoxy, 1-methylpropoxy and t-butoxy;
cyano group; and
cyanoalkyl groups of 2 to 6 carbon atoms, such as cyanomethyl, 2-cyanoethyl, 3-cyanopropyl and 4-cyanobutyl.

Examples of such monomers (3') include t-butyl (meth)acrylate, 1,1-dimethylpropyl (meth)acrylate, 1,1-dimethylbutyl (meth)acrylate, 2-cyclohexylpropyl (meth)acrylate, 1,1-dimethylphenyl (meth)acrylate, tetrahydropyranyl (meth)acrylate, 2-t-butoxycarbonylmethyl (meth)acrylate, 2-benzyloxycarbonylethyl (meth)acrylate, 2-methyladamantyl (meth)acrylate, 1,1-dimethyl-3-oxobutyl (meth)acrylate and 2-benzylpropyl (meth)acrylate.

As the monomer (I), a monomer which is dissociated by an acid to form a phenolic hydroxyl group is also employable.

Examples of such monomers include hydroxystyrenes protected by an acetal group, such as p-1-methoxyethoxystyrene and p-1-ethoxyethoxystyrene; t-butoxystyrene, and t-butoxycarbonyloxystyrene.

The acid-dissociable functional group (b) of the polymer (A) undergoes reaction by means of an acid to form not only an acidic functional group but also an acid dissociation product. For example, in the case where 2-benzylpropyl (meth)acrylate is used as the monomer (I) to introduce the acid-dissociable functional group (b) into the polymer (A), the resulting acid dissociation product is 2-benzylpropene.

If the boiling point of the acid dissociation product at 1 atm (referred to as a "boiling point" simply hereinafter) is not higher than room temperature, an evil influence is liable to be exerted on the pattern shape in the production of a plated shaped article.

In the case where the thickness of the resist film is in the range of about 1 to 50 µm as in the case of forming a circuit of an integrated circuit device, even an acid dissociation product having a boiling point of lower than 20°C generally penetrates the resist film as a gas component in the PEB step, so that the acid dissociation product does not actually exert an influence on the pattern shape. In the production of a bump or the like, however, the thickness of the resist film must be sometimes made not less than 50 µm. In the case where the thickness of the resist film must be made not less than 50 µm, a gas component generated remains in the resist film and forms large bubbles. As a result, the pattern shape is liable to be markedly impaired when the resist is developed. On this account, when the acid dissociation product has a low boiling point, particularly a boiling point of lower than 20°C, it is difficult to apply the composition to uses where the thickness of the resist film exceeds 50 µm.

Accordingly, the monomer (I) is preferably a monomer by the use of which the acid dissociation product formed from the polymer (A) has a boiling point of not lower than 20°C. Examples of such monomers include 1,1-dimethyl-3-oxobutyl (meth)acrylate, 2-benzylpropyl (meth)acrylate, 2-cyclohexylpropyl (meth)acrylate and 1,1-dimethylbutyl (meth)acrylate. Of these, 1,1-dimethyl-3-oxobutyl (meth)acrylate or 2-benzylpropyl (meth)acrylate is preferable. The acid dissociation product derived from the 1,1-dimethyl-3-oxobutyl (meth)acrylate is 4-methyl-4-penten-2-one, and its boiling point is about 130°C. The acid dissociation product derived from the 2-benzylpropyl (meth)acrylate is 2-benzylpropene, and its boiling point is about 170°C.

The above monomers (I) can be used singly or as a mixture of two or more kinds.

For preparing the polymer (A), a copolymerizable monomer (referred to as a "monomer (II)" hereinafter) other than the monomers (1'), (2') and (I) may be also copolymerized.

Examples of the monomers (II) include:
aromatic vinyl compounds, such as o-hydroxystyrene, m-hydroxystyrene, p-hydroxystyrene, p-isopropenylphenol, styrene, α-methylstyrene, p-methylstyrene and p-methoxystyrene;
hetero atom-containing alicyclic vinyl compounds, such as N-vinylpyrrolidone and N-vinylcaprolactam;
cyano group-containing vinyl compounds, such as acrylonitrile and methacrylonitrile;
conjugated diolefins, such as 1,3-butadiene and isoprene;
amide group-containing vinyl compounds, such as acrylamide and methacrylamide;
carboxyl group-containing vinyl compounds, such as acrylic acid and methacrylic acid; and
(meth)acrylic esters, such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono(meth)acrylate, polypropylene glycol mono(meth)acrylate, glycerol mono(meth)acrylate, phenyl (meth)acrylate, benzyl (meth)acrylate, cyclohexyl (meth)acrylate, isobornyl (meth)acrylate and tricyclodecanyl (meth)acrylate.

Of the above monomers (II), preferable are p-hydroxystyrene, p-isopropenyphenol, styrene, acrylic acid, methacrylic acid, methyl (meth)acrylate, ethyl (meth)acrylate, n-butyl (meth)acrylate, 2-hydroxyethyl (meth)acrylate, 2-hydroxypropyl (meth)acrylate, benzyl (meth)acrylate and isobornyl (meth)acrylate.

The monomers (II) can be used singly or as a mixture of two or more kinds.

The content of the acid-dissociable functional group (b) is not specifically restricted provided that it is within the limits not detrimental to the effect of the present invention.

In the case where the acid-dissociable functional group (b) is derived from the monomer (I), the ratio of the units derived from the monomer (I) contained in the polymer (A) to the units derived from other monomers than the monomer (I) is not specifically restricted provided that it is within the limits not detrimental to the effect of the present invention. However, the weight ratio of the units derived from the monomer (I) to the total of the units derived from the monomers (1') and (2') and the units derived from the monomer (II), namely, monomer (I)/(monomer (1') + monomer (2') + monomer (II)), is in the range of usually 5/95 to 95/5, preferably 10/90 to 90/10, more preferably 20/80 to 80/20.

If the ratio of the units derived from the monomer (I) is less than the lower limit of the above range, the proportion of the resulting acidic functional group is low, so that the solubility of the resulting polymer in an alkali developing solution is lowered, and as a result, pattern formation sometimes becomes difficult.

The polymer (A) can be prepared by, for example, directly copolymerizing the monomer (1') and/or the monomer (2'), the monomer (I), and if necessary, the monomer (II).

The polymerization can be carried out by a radical polymerization process. As the polymerization initiator, a usual radical polymerization initiator is employable. Examples of the polymerization processes include emulsion polymerization, suspension polymerization, solution polymerization and bulk polymerization. Of these, solution polymerization is particularly preferable.

Examples of the radical polymerization initiators include azo compounds, such as 2,2'-azobisisobutyronitrile (AIBN) and 2,2'-azobis-(2,4-dimethylvaleronitrile); and organic peroxides, such as benzoyl peroxide, lauryl peroxide and t-butyl peroxide.

The solvent for use in the solution polymerization is not specifically restricted provided that it has no reactivity to the monomer components used and is capable of dissolving the resulting polymer. Examples of such solvents include methanol, ethanol, n-hexane, toluene tetrahydrofuran, 1,4-dioxane, ethyl acetate, n-butyl acetate, acetone, methyl ethyl ketone, methyl isobutyl ketone, 2-hepatanone, cyclohexanone, ethylene glycol monomethyl ether, propylene glycol monomethyl ether, propylene glycol monomethyl ether acetate, methyl 3-methoxypropionate, ethyl 3-ethoxypropionate, ethyl lactate and γ-butyrolactone.

The above solvents can be used singly or as a mixture of two or more kinds.

When the polymer (A) is prepared by solution polymerization, the polymer solution obtained may be used as it is in the preparation of the positive radiation-sensitive resin composition, or after the polymer (A) is separated from the polymer solution, the polymer may be used in the preparation of the positive radiation-sensitive resin composition.

In the polymerization, a molecular weight modifier such as a mercaptan compound or a halogenated hydrocarbon can be used, when needed.

The molecular weight of the polymer (A) can be controlled by properly selecting polymerization conditions, such as types and amounts of monomers, radical polymerization initiator, molecular weight modifier and polymerization temperature. The polymer (A) has a weight-average molecular weight (Mw), in terms of polystyrene, of usually 5,000 to 300,000, preferably 7,000 to 200,000.

When Mw of the polymer (A) is in the above range, the resin film has sufficient strength and sufficient plating resistance, exhibits excellent alkali solubility after exposure of the polymer, and easily forms a fine pattern.

In the present invention, the polymers (A) can be used singly or as a mixture of two or more kinds.

### Acid generator (B)

The radiation-sensitive acid generator (referred to as an "acid generator (B)" hereinafter) for use in the invention is a compound which generates an acid upon exposure. By virtue of an action of the acid generated, the acid-dissociable functional group present in the polymer (A) is dissociated to form an acidic functional group such as a carboxyl group or a phenolic hydroxyl group. As a result, the exposed portion of the resin film formed from the positive radiation-sensitive resin composition comes to have easy solubility in an alkali developing solution, and a positive pattern can be formed.

The acid generator (B) is, for example, an onium salt compound (including thiophenium salt compound), a halogen-containing compound, a diazoketone compound, a sulfone compound, a sulfonic acid compound, a sulfonimide compound or a diazomethane compound. Examples of these compounds are given below.

Examples of the onium salt compounds include iodonium salts, sulfonium salts, phosphonium salts, diazonium salts and pyridinium salts.

Preferred examples of the onium salt compounds include diphenyliodonium trifluoromethanesulfonate, diphenyliodonium p-toluenesulfonate, diphenyliodonium hexafluoroantimonate, diphenyliodonium hexafluorophosphate, diphenyliodonium tetrafluoroborate, triphenylsulfonyl trifluoromethanesulfonate, triphenyl hexafluoroantimonate, triphenylsulfonium hexafluorophosphate, 4-t-butylphenyl·diphenylsulfonium trifluoromethanesulfonate, 4-t-butylphenyl·diphenylsulfonium perfluoro-n-octanesulfonate, 4-t-butylphenyl·diphenylsulfonium pyrenesulfonate, 4-t-butylphneyl·diphenylsulfonium n-dodecylbenzenesulfonate, 4-t-butylphenyl·diphenylsulfonium p-toluenesulfonate, 4-t-butylphenyl·diphenylsulfonium benzenesulfonate and 4,7-di-n-butoxynaphthyltetrahydrothiophenium trifluoromethanesulfonate.

Examples of the halogen-containing compounds include haloalkyl group-containing hydrocarbon compounds and haloalkyl group-containing heterocyclic compounds.

Preferred examples of the halogen-containing compounds include 1,10-dibromo-n-decane, 1,1-bis(4-chlorophenyl)-2,2,2-trichoroethane, and (trichloromethyl)-s-triazine derivatives, such as phenyl-bis(trichloromethyl)-s-triazine, 4-methoxyphenyl-bis(tricholoromethyl)-s-triazine, styryl-bis(trichloromethyl)-s-triazine and naphthyl-bis(trichloromethyl)-s-triazine.

Examples of the diazoketone compounds include 1,3-diketo-2-diazo compounds, diazobenzoquinone compounds and diazonaphthoquinone compounds.

Preferred examples of the diazoketone compounds include 1,2-naphthoquinonediazido-4-sulfonic esters of phenols and 1,2-naphthoquinonediazido-5-sulfonic esters of phenols.

Examples of the sulfone compounds include β-ketosulfone, β-sulfonylsulfone and α-diazo compounds of these compounds.

Preferred examples of the sulfone compounds include 4-trisphenacylsulfone, mesitylphenacylsulfone and bis(phenylsulfonyl)methane.

Examples of the sulfonic acid compounds include alkylsulfonic esters, haloalkylsulfonic esters, arylsulfonic esters and iminosulfonates.

Preferred examples of the sulfonic acid compounds include benzoin tosylate, pyrogallol tristrifluoromethanesulfonate, o-nitrobenzyl trifluoromethanesulfonate and o-nitrobenzyl p-toluenesulfonate.

Examples of the sulfonimide compounds include N-(trifluoromethylsulfonyloxy)succinimde, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-ene-2,3-dicarboxyimide, N-(trifluoromethylsulfonyloxy)-7-oxabicyclo[2.2.1]hept-5-ene-2,3-dicarboxyimide, N-(trifluoromethylsulfonyloxy)bicyclo[2.2.1]heptan-5,6-oxy-2,3-dicarboxyimide, N-(trifluoromethylsulfonyloxy)naphthylimide, N-(4-methylphenylsulfonyloxy)succinimide, N-(4-methylphenylsulfonyloxy)phthalimide, N-(4-methylphenylsulfonyloxy)diphenylmaleimide, N-(4-methylphenylsulfonyloxy)bicyclo[2.2.1]hept-5-ene-2,3-dicarboxyimide, N-(4-methylphenylsulfonyloxy)-7-oxabicyclo[2.2.1]hept-5-ene-2,3-dicarboxyimide, N-(4-methylphenylsulfonyloxy)bicyclo[2.2.1]heptan-5,6-oxy-2,3-dicarboxyimide, N-(4-methylphenylsulfonyloxy)naphthylimide, N-(2-trifluoromethylphenylsulfonyloxy)succinimide, N-(2-trifluoromethylphenylsulfonyloxy)phthalimide, N-(2-trifluoromethylphenylsulfonyloxy)diphenylmaleimide, N-(2-trifluoromethylphenylsulfonyloxy)bicyclo[2.2.1]hept-5-ene-2,3-dicarboxyimide, N-(2-trifluoromethylphenylsulfonyloxy)-7-oxabicyclo[2.2.1]hept-5-ene-2,3-dicarboxyimide, N-(2-trifluoromethylphenylsulfonyloxy)bicyclo[2.2.1]heptan-5,6-oxy-2,3-dicarboxyimide, N-(2-trifluoromethylphenylsulfonyloxy)naphthylimide, N-(4-fluorphenylsulfonyloxy)succinimide, N-(4-fluorophenylsulfonyloxy)-7-oxabicyclo[2.1.1]hept-5-ene-2,3-dicarboxyimide, N-(4-fluorophenylsulfonyloxy)bicyclo]2.1.1]heptan-5,6-oxy-2,3-dicarboxyimide, N-(4-fluorophenylsulfonyloxy)naphthylimide and N-(10-camphorsulfonyloxy)naphthylimide.

Examples of the diazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, methylsulfonyl-p-toluenesulfonyldiazomethane, cyclohexylsulfonyl-1,1-dimethylethylsulfonyldiazomethane and bis(1,1-dimethylethylsulfonyl)diazomethane.

Of the above acid generators (B), 4-t-butylphenyl·diphenylsulfonium trifluoromethanesulfonate, 4-t-butylphenyl·diphenylsulfonium perfluoro-n-octanesulfonate, 4-t-butylphenyl·diphenylsulfonium pyrenesulfonate and 4,7-di-n-butoxynaphthyltetrahydrothiophenium trifluoromethanesulfonate are more preferable, and 4-t-butylphenyl·diphenylsulfonium trifluoromethanesulfonate and 4,7-di-n-butoxynaphthyltetrahydrothiophenium trifluoromethanesulfonate are particularly preferable.

In the present invention, the acid generators (B) can be used singly or as a mixture of two or more kinds.

From the viewpoint of security of sensitivity, resolution and pattern shape of the resist, the amount of the acid generator (B) used is in the range of usually 0.1 to 20 parts by weight, preferably 0.3 to 10 parts by weight, based on 100 parts by weight of the polymer (A). When the amount of the acid generator (B) used is in the above range, a resist having excellent sensitivity, resolution and transparency to radiation is obtained, and a pattern of excellent shape is obtained.

### Organic solvent (C)

The positive radiation-sensitive resin composition of the invention can be diluted with an organic solvent (C) for the purpose of homogeneously mixing the polymer (A), the acid generator (B), other alkali-soluble resin (D) described later and additives which are added when needed.

As the organic solvent, the solvent previously exemplified with regard to the solution polymerization for preparing the polymer (A) is employable. In addition, dimethyl sulfoxide, acetonylacetone, isophorone, propylene carbonate, etc. are also employable. These organic solvents can be used singly or as a mixture of two or more kinds.

The amount of the organic solvent (C) used can be controlled by considering a method for applying the positive radiation-sensitive resin composition, uses of the composition for producing a plated shaped article, etc. Although the amount of the organic solvent (C) is not specifically restricted provided that the composition can be homogeneously mixed, the organic solvent (C) is desirably contained in an amount of preferably 20 to 80 parts by weight, more preferably 30 to 70 parts by weight, based on the total weight 100 parts by weight of the positive radiation-sensitive resin composition. When the amount of the organic solvent (C) is in the above range, the thickness of a resin film formed by applying the composition can be made uniform, and the shape of a desired high bump can be made uniform.

### Other alkali-soluble resin

To the positive radiation-sensitive resin composition of the invention, an alkali-soluble resin other than the polymer (A) (referred to as "other alkali-soluble resin (D)" hereinafter) can be added on certain occasions.

The other alkali-soluble resin (D) is a resin which has one or more functional groups showing affinity for an alkali developing solution, e.g., acidic functional groups such as a phenolic hydroxyl group and a carboxyl group, and is soluble in an alkali developing solution.

By adding such an alkali-soluble resin, control of solubility speed of a resin film formed from the positive radiation-sensitive resin composition in an alkali developing solution can be made easier, and therefore, developability can be further enhanced.

The other alkali-soluble resin (D) is not specifically restricted as long as it is soluble in an alkali developing solution. Examples of the resins (D) include addition polymerization type resins obtained by polymerizing at least one monomer having an acidic functional group, such as o-hydroxystyrene, m-hydroxystyrene, p-hydroxystyrene, p-isopropenylphenol, p-vinylbenzoic acid, p-carboxymethylstyrene, p-carboxymethoxystyrene, acrylic acid, methacrylic acid, crotonic acid, maleic acid, fumaric acid, itaconic acid, citraconic acid, mesaconic acid and cinnamic acid; and polycondensation type resins having an acidic functional group, such as a novolak resin.

The addition polymerization type alkali-soluble resin may be constituted of only recurring units formed by cleavage of polymerizable unsaturated bonds of the monomer having an acidic functional group, but the resin can further contain one or more kinds of other recurring units as long as the resulting resin is soluble in an alkali developing solution.

Examples of other recurring units include those of styrene, α-methylstyrene, o-vinyltoluene, m-vinyltoluene, p-vinyltoluene, maleic anhydride, acrylonitrile, methacrylonitrile, crotonitrile, maleinitrile, fumaronitrile, mesaconitrile, citraconitrile, itaconitrile, acrylamide, methacryliamide, crotonamide, maleinamide, fumaramide, mesaconamide, citraconamide, itaconamide, 2-vinylpyridine, 3-vinylpyridine, 4-vinylpyridine, N-vinylaniline, N-vinyl-ε-caprolactam, N-vinylpyrrolidone and N-vinylimidazole.

The addition polymerization type alkali-soluble resin is particularly preferably poly(p-hydroxystyrene) or a copolymer of p-isopropenylphenol from the viewpoints that radiation transmittance of the resulting resin film is high and dry etching resistance thereof is excellent.

The addition polymerization type alkali-soluble resin has a weight-average molecular weight (Mw), in terms of polystyrene, of usually 1,000 to 200,000, preferably 5,000 to 50,000.

The polycondensation type alkali-soluble resin may be constituted of only condensation recurring units having an acidic functional group, but the resin can further contain other condensation recurring units as long as the resulting resin is soluble in an alkali developing solution.

Such a polycondensation type resin can be prepared by, for example, (co)polycondensing one or more phenols and one or more aldehydes, and in certain cases, together with a polycondensation component capable of forming other condensation recurring units, in a water medium or a mixed medium of water and a hydrophilic solvent in the presence of an acid catalyst or a basic catalyst.

Examples of the phenols include o-cresol, m-cresol, p-cresol, 2,3-xylenol, 2,4-xylenol, 2,5-xylenol, 3,4-xylenol, 3,5-xylenol, 2,3,5-trimethylphenol and 3,4,5-trimethylphenol. Examples of the aldehydes include formaldehyde, trioxane, paraformaldehyde, benzaldehyde, acetaldehyde, propylaldehyde and phenylacetaldehyde.

The polycondensation type alkali-soluble resin has a weight-average molecular weight (Mw), in terms of polystyrene, of usually 1,000 to 100,000, preferably 2,000 to 50,000.

The above-mentioned other alkali-soluble resins can be used singly or as a mixture of two or more kinds. The amount of the other alkali-soluble resin used is usually not more than 200 parts by weight based on 100 parts by weight of the polymer (A).

### Acid diffusion controller

In order to control diffusion of an acid generated from the acid generator (B) into the resin film and thereby inhibit undesirable chemical reaction in the unexposed portion, it is preferable to add an acid diffusion controller to the positive radiation-sensitive resin composition of the invention. By the use of the acid diffusion controller, storage stability of the composition is improved, and resolution of the resist can be increased. In addition, change of line width of the pattern attributable to variation of the post-exposure delay time between exposure and PEB can be inhibited, and the process stability becomes very excellent.

The acid diffusion controller is preferably a nitrogen-containing organic compound whose basicity is not changed by exposure or heating in the production process of a plated shaped article.

Examples of the nitrogen-containing organic compounds include n-hexylamine, n-heptylamine, n-octylamine, n-nonylamine, ethylenediamine, N,N,N',N'-tetramethylethylenediamine, tetamethylenediamine, hexamethylenediamine, 4,4'-diaminodiphenylmethane, 4,4'-diaminodiphenyl ether, 4,4'-diaminobenzophenone, 4,4'-diaminodiphenylamine, formamide, N-methylformamide, N,N-dimethylformamide, acetamide, N-methylacetamide, N,N-dimethylacetamide, propionamide, benzamide, pyrrolidone, N-methylpyrrolidone, methylurea, 1,1-dimethylurea, 1,3-dimethylurea, 1,1,3,3-tetramethylurea, 1,3-diphenylurea, imidazole, benzimidazole, 4-methylimidazole, 8-oxyquinoline, acridine, purine, pyrrolidine, piperidine, 2,4,6-tri(2-pyridyl)-s-triazine, morpholine, 4-methylmorpholine, piperazine, 1,4-dimethylpiperazine and 1,4-diazabicyclo[2.2.2]octane. Of these nitrogen-containing organic compounds, 2,4,6-tri(2-pyridyl)-s-triazine is particularly preferable.

The acid diffusion controllers can be used singly or as a mixture of two or more kinds.

The amount of the acid diffusion controller used is usually not more than 15 parts by weight, preferably 0.001 to 10 parts by weight, more preferably 0.005 to 5 parts by weight, based on 100 parts by weight of the polymer (A). When the amount of the acid diffusion controller is in the above range, a resist excellent in sensitivity, developability, pattern shape and dimensional fidelity can be obtained.

### Surface active agent

In order to improve coating property, developability, etc., a surface active agent can be added to the positive radiation-sensitive resin composition of the invention.

Examples of the surface active agents include polyoxyethylene lauryl ether, polyoxyethylene stearyl ether, polyoxyethylene oleyl ether, polyoxyethylene n-octylphenol ether, polyoxyethylene n-nonylphenol ether, polyethylene glycol dilaurate and polyethylene glycol distearate.

The above surface active agents can be used singly or as a mixture of two or more kinds. The amount of the surface active agent used is usually not more than 2 parts by weight based on 100 parts by weight of the polymer (A).

### Other additives

As other additives which can be added to the positive radiation-sensitive resin composition of the invention, there can be mentioned, for example, ultraviolet light absorber, sensitizer, dispersant, plasticizer, thermal polymerization inhibi0tor for enhancing storage stability, and antioxidant. Above all, the ultraviolet light absorber is useful because it has a function of inhibiting photo reaction caused by entering of scattered light into the unexposed portion in the exposure step. Such an ultraviolet light absorber is preferably a compound having a high absorptivity coefficient in the wavelength region of ultraviolet light used for the exposure. Further, an organic pigment is also employable for the same purpose.

The positive radiation-sensitive resin composition of the invention is excellent in heat resistance in the PEB step, wettability of the resin film by a developing solution, and adhesion of the resin film to a substrate. Particularly, high heat resistance of the resin composition in the PEB step is very important for the contribution to resolution of a resist, so that the resin composition can be preferably used for producing a plated shaped article such as a bump or a wiring of an integrated circuit device.

The process for producing a plated shaped article according to the invention comprises:
(1) a step of forming a resin film composed of the above-described positive radiation-sensitive resin composition on a wafer having a barrier metal layer,
(2) a step of exposing the resin film and then developing the resin film to form a pattern,
(3) a step of depositing an electrode material by electroplating using the pattern as a mold, and
(4) a step of stripping the remaining resin film and then removing the barrier metal by etching.

The resin film formed in the step (1) can be obtained by applying the resin composition of the invention onto a wafer and drying the composition. Further, the resin film can be obtained also by the use of the below-described transfer film of the invention, and specifically, the resin film can be obtained by transferring a resin film onto a wafer from the transfer film.

The transfer film of the invention has a resin film composed of the positive radiation-sensitive resin composition on a support film. Such a transfer film can be prepared by applying the positive radiation-sensitive resin composition onto a support film and drying the composition. Examples of methods to apply the composition include spin coating, roll coating, screen printing and applicator method. The material of the support film is not specifically restricted as long as the material has a strength capable of withstanding preparation and uses of a transfer film.

In the transfer film employable as the present invention, the thickness of the resin film is in the range of 20 to 200 µm.

By peeling the support film from the transfer film of the invention, a positive radiation-sensitive resin film can be obtained. The resin film thus obtained can be used for producing a plated shaped article, similarly to the case of using the composition of the invention.

### EXAMPLES

The present invention is further described with reference to the following examples, but it should be construed that the invention is in no way limited to those examples. In the following examples, the terms "part(s)" and "%" mean "part(s) by weight" and "% by weight", respectively, unless otherwise noted.

### Synthesis of polymer (A)

### Synthesis Example 1

20 g of p-hydroxyphenyl methacrylamide, 20 g of p-isopropenylphenol, 20 g of 2-hydroxyethyl acrylate, 20 g of isobornyl acrylate and 30 g of 2-benzyl-2-propyl methacrylate were mixed with 150 g of ethyl lactate, and the mixture was stirred at 50°C to give a homogeneous solution. After a nitrogen gas was bubbled through the solution for 30 minutes, 4 g of AIBN was added. With continuing bubbling of a nitrogen gas and maintaining the reaction temperature at 70°C, polymerization was carried out for 7 hours. After the polymerization was completed, the reaction solution was mixed with a large amount of hexane to solidify the resulting polymer. Subsequently, the polymer was redissolved in tetrahydrofuran and then solidified by the use of hexane again. These operations were repeated several times to remove the unreacted monomers, and the resulting polymer was dried at 50°C under reduced pressure to obtain a white polymer A1.

### Synthesis Examples 2 to 10

Copolymers A2 to A10 were synthesized in the same manner as in the synthesis of the copolymer A1 of Synthesis Example 1, except that the types and the amounts of the compounds were changed in accordance with compositions of Table 1. Further, copolymers A11 to A25 were synthesized in the same manner as in the synthesis of the copolymer A1 of Synthesis Example 1, except that the solvent used was changed to propylene glycol monomethyl ether acetate.

### Synthesis of polymer for comparison

### Synthesis Example 11

30 g of p-isopropenylphenol, 20 g of 2-hydroxyethyl acrylate and 50 g of 2-benzyl-2-propyl acrylate were mixed with 150 g of ethyl lactate to give a homogeneous solution. After a nitrogen gas was bubbled through the solution for 30 minutes, 4 g of AIBN was added. With continuing bubbling of a nitrogen gas and maintaining the reaction temperature at 70°C, polymerization was carried out for 7 hours. After the polymerization was completed, the reaction solution was mixed with a large amount of hexane to solidify the resulting polymer. Subsequently, the polymer was redissolved in tetrahydrofuran and then solidified by the use of hexane again. These operations were repeated several times to remove the unreacted monomers, and the resulting polymer was dried at 50°C under reduced pressure to obtain a white polymer R1.

### Synthesis Examples 12 and 13

Copolymers R2 and R3 were synthesized in the same manner as in the synthesis of the copolymer R1 of Synthesis Example 11, except that the types and the amounts of the compounds were changed in accordance with compositions of Table 1.

### Synthesis of polymer (D)

### Synthesis Example 14

30 g of p-isopropenylphenol, 30 g of 2-hydroxyethyl acrylate, 35 g of n-butyl acrylate, 5 g of 2-methoxyethyl acrylate and 1 g of n-hexyl 1,6-dimethacrylate were mixed with 150 g of propylene glycol monomethyl ether acetate to give a homogeneous solution. After a nitrogen gas was bubbled through the solution for 30 minutes, 4 g of AIBN was added. With continuing bubbling of a nitrogen gas and maintaining the reaction temperature at 80°C, polymerization was carried out for 6 hours. After the polymerization was completed, the reaction solution was mixed with a large amount of hexane to solidify the resulting polymer. Subsequently, the polymer was redissolved in tetrahydrofuran and then solidified by the use of hexane again. These operations were repeated several times to remove the unreacted monomers, and the resulting polymer was dried at 50°C under reduced pressure to obtain a white polymer D1.

### Synthesis Example 15

50 g of 2-hydroxyethyl methacrylate, 40 g of n-butyl acrylate and 10 g of 2-methacryloyloxyethyl hexahydrophthalate were mixed with 150 g of ethyl lactate to give a homogeneous solution. After a nitrogen gas was bubbled through the solution for 30 minutes, 4 g of AIBN was added. With continuing bubbling of a nitrogen gas and maintaining the reaction temperature at 80°C, polymerization was carried out for 6 hours. After the polymerization was completed, the reaction solution was mixed with a large amount of hexane to solidify the resulting polymer. Subsequently, the polymer was redissolved in tetrahydrofuran and then solidified by the use of hexane again. These operations were repeated several times to remove the unreacted monomers, and the resulting polymer was dried at 50°C under reduced pressure to obtain a white polymer D2. The polymer was dissolved in ethyl lactate to give a solution having a concentration of 50% by weight, and this solution was used.

### Example 1

### Preparation of resin composition

In 150 parts by weight of ethyl lactate (organic solvent (C1)), 100 parts by weight of the polymer (A1), 3 parts by weight of 4,7-di-n-butoxynaphthyltetrahydrothiophenium trifluoromethanesulfonate (acid generator (B)) and 20 parts by weight of the polymer (D1) were dissolved, and the resulting solution was filtered through a Teflon (R) membrane filter having a pore diameter of 3 µm to prepare a resin composition.

### Preparation of gold sputtered substrate

On a silicon wafer substrate having a diameter of 4 inches, chromium was sputtered in a thickness of about 500 Å, and then gold was further sputtered thereon in a thickness of 1,000 Å to form a conductive layer. This substrate provided with the conductive layer is referred to as a "gold sputtered substrate" hereinafter.

### Formation of pattern

The gold sputtered substrate was coated with the resin composition by means of a spin coater and then heated on a hot plate at 120°C for 5 minutes to form a resin film having a thickness of 25 µm. Subsequently, the resin film was irradiated with ultraviolet light of 300 to 1500 mJ/cm² using an extra-high pressure mercury lamp (OSRAM HBO, output: 1,000 W) through a pattern mask. The quantity of light for exposure was confirmed by an illuminance meter (UV-M10 (illuminance meter, manufactured by ORC Manufacturing Co., Ltd.) to which a probe UV-35 (receptor) had been connected). After the exposure, PEB was carried out on a hot plate at 100°C for 5 minutes. Subsequently, the resin film was immersed in a 2.38 wt% tetramethylammonium hydroxide aqueous solution at room temperature for 1 to 5 minutes to develop the resin film, then washed with running water and subjected to nitrogen blowing to form a pattern. This substrate provided with the pattern is referred to as a "patterning substrate (A)" hereinafter.

### Formation of plated shaped article

The patterning substrate (A) was subjected to ashing treatment with oxygen plasma (output: 100 W, oxygen flow rate: 100 ml, treating time: 1 minute) as pretreatment for electroplating, to make the patterning substrate hydrophilic. Subsequently, the substrate was immersed in 1 liter of a gold cyanide plating solution (available from Electroplating Engineers of Japan Ltd., trade name: Temperex 401) and subjected to electroplating for about 60 minutes under the conditions of a plating bath temperature of 42°C and a current density of 0.6 A/dm² to form a plated shaped article for a bump having a thickness of 15 to 18 µm. Then, the substrate was washed with running water and blown by a nitrogen gas to dry it. Thereafter, the substrate was immersed in a mixed solution of dimethyl sulfoxide and N,N-dimethylformamide (weight ratio = 50:50) at room temperature for 5 minutes to strip the resin film portion, and then a portion of the conductive layer on the substrate other than the region where the plated shaped article had been formed was removed by wet etching to obtain a substrate having a plated shaped article. This substrate having the plated shaped article is referred to as a "plated substrate (A)" hereinafter.

### Evaluation

### (1) Sensitivity

A quantity of light for exposure, by which a dimension of a bottom of a removed pattern becomes 30 µm when a pattern of 40 µm pitch in a mask design dimension (removed pattern of 30 µm width/remaining pattern of 10 µm width) is formed on a gold sputtered substrate, was taken as an optimum quantity of light for exposure, and the sensitivity was evaluated by this optimum quantity of light for exposure.

### (2) Resolution

Two kinds of patterns of 40 µm pitch in a mask design dimension (removed pattern of 30 µm width/remaining pattern of 10 µm width, removed pattern of 32 µm width/remaining pattern of 8 µm width) were formed on substrates separately to prepare two patterning substrates (A). These two patterning substrates (A) were observed by a light microscope and a scanning electron microscope and evaluated based on the following criteria.
AA: The removed pattern of 32 µm width/remaining pattern of 8 µm width could be resolved.
BB: Although the removed pattern of 30 µm width/remaining pattern of 10 µm width could be resolved, the removed pattern of 32 µm width/remaining pattern of 8 µm width could not be resolved.
CC: The pattern of 40 µm pitch could not be resolved or could not be resolved with good reproducibility.

### (3) Crack resistance

Using the patterning substrate (A), a plated shaped article for a bump was formed in the same manner as in the formation of the aforesaid plated shaped article. Then, the substrate was washed with running water and blown by a nitrogen gas to dry it. The resulting substrate (i.e., substrate from which the resin film portion had not been stripped) was allowed to stand in a clean room kept at room temperature (23°C) and a humidity of about 45%. After a lapse of 3 hours and a lapse of 24 hours, the substrate surface was observed by a light microscope, and the substrate was evaluated based on the following criteria. The term "remaining pattern" used herein corresponds to a resist pattern.
AA: Even after 24 hours, no crack occurs in the remaining pattern.
BB: After 3 hours, no crack occurs in the remaining pattern, but after 24 hours, a crack occurs in the remaining pattern.
CC: After 3 hours, a crack occurs in the remaining pattern.

### (4) Dimensional fidelity of pattern

The patterning substrate (A) provided with a pattern of 40 µm pitch in a mask dimension (removed pattern of 30 µm width/remaining pattern of 10 µm width) was observed by a light microscope and a scanning electron microscope, and a top dimension (Wt) and a bottom dimension (Wb) of the removed pattern were measured to evaluate the dimensional fidelity of the pattern to the mask dimension (30 µm).

### (5) Shape (A) of plated portion

The plated substrate (A) provided with a pattern of 40 µm pitch in a mask dimension (removed pattern of 30 µm width/remaining pattern of 10 µm width) was observed by a light microscope and a scanning electron microscope, and the substrate was evaluated based on the following criteria.
AA: The shape of the plated portion has been transferred from the shape of the pattern formed from the resin film with fidelity, and any abnormal nodular protrusion is not observed.
BB: The shape of the plated portion has not been transferred from the shape of the pattern formed from the resin film with fidelity, and an abnormal nodular protrusion is observed.

### (6) Shape (B) of plated portion

The plated substrate (A) provided with a pattern of 40 µm pitch in a mask dimension (removed pattern of 30 µm width/remaining pattern of 10 µm width) was observed by a light microscope and a scanning electron microscope, and the substrate was evaluated based on the following criteria.
AA: The shape of the bottom of the plated portion has been transferred from the shape of the pattern formed from the resin film with fidelity, and traces of introduction of the plating solution between the bottom of the pattern and the surface of the substrate are not observed.
BB: The shape of the bottom of the plated portion has not been transferred from the shape of the pattern formed from the resin film with fidelity, and traces of introduction of the plating solution between the bottom of the pattern and the surface of the substrate are observed.

### (7) Dimensional fidelity of plated portion

The plated substrate (A) obtained by forming a plated shaped article on the patterning substrate (A) provided with a pattern of 40 µm pitch in a mask dimension (removed pattern of 30 µm width/remaining pattern of 10 µm width) was observed by a light microscope and a scanning electron microscope, and a top dimension (Wt) and a bottom dimension (Wb) of the plated portion were measured to evaluate the dimensional fidelity of plated portion to the mask dimension (30 µm).

The evaluation results are set forth in Table 3.

### Example 2

A resin composition was prepared in the same manner as in Example 1, except that the components and the amounts thereof were changed to those shown in Example 2 of Table 2. Then, formation of a pattern, formation of a plated shaped article and evaluations were carried out in the same manner as in Example 1. The evaluation results are set forth in Table 3.

### Example 3

A resin composition was prepared in the same manner as in Example 1, except that the components and the amounts thereof were changed to those shown in Example 3 of Table 2, and 2,4,6-tri(2-pyridyl)-s-triazine (acid diffusion controller (E)) was added in an amount of 0.05 part by weight based on 100 parts by weight of the polymer (A1). Then, formation of a pattern, formation of a plated shaped article and evaluations were carried out in the same manner as in Example 1. The evaluation results are set forth in Table 3.

### Example 4

A resin composition was prepared in the same manner as in Example 3, except that the components and the amounts thereof were changed to those shown in Example 4 of Table 2. Then, formation of a pattern, formation of a plated shaped article and evaluations were carried out in the same manner as in Example 1. The evaluation results are set forth in Table 3.

### Example 5

A resin composition was prepared in the same manner as in Example 3, except that the components and the amounts thereof were changed to those shown in Example 5 of Table 2, and the polymer (A2) was used instead of the polymer (A1). Then, formation of a pattern, formation of a plated shaped article and evaluations were carried out in the same manner as in Example 1. The evaluation results are set forth in Table 3.

### Example 6

A resin composition was prepared in the same manner as in Example 3, except that the components and the amounts thereof were changed to those shown in Example 6 of Table 2, and polyvinyl methyl ether (polymer (D3), Mw: 50,000, available from Tokyo Kasei Kogyo Co., Ltd.) was used instead of the polymer (D1). Then, formation of a pattern, formation of a plated shaped article and evaluations were carried out in the same manner as in Example 1. The evaluation results are set forth in Table 3.

The polymer (D3) was used as a solution having a concentration of 50% by weight, which had been obtained by subjecting an ethanol solution of the polymer having a concentration of 50% by weight to solvent replacement with ethyl lactate by means of a rotary evaporator.

### Example 7

A resin composition was prepared in the same manner as in Example 1, except that the components and the amounts thereof were changed to those shown in Example 7 of Table 2, and the polymer (A2) was used instead of the polymer (A1). Then, formation of a pattern, formation of a plated shaped article and evaluations were carried out in the same manner as in Example 1. The evaluation results are set forth in Table 3.

### Example 8

A resin composition was prepared in the same manner as in Example 1, except that the components and the amounts thereof were changed to those shown in Example 8 of Table 2, and the polymer (A3) was used instead of the polymer (A1). Then, formation of a pattern, formation of a plated shaped article and evaluations were carried out in the same manner as in Example 1. The evaluation results are set forth in Table 3.

### Example 9

A resin composition was prepared in the same manner as in Example 1, except that the components and the amounts thereof were changed to those shown in Example 9 of Table 2, and the polymer (A4) was used instead of the polymer (A1). Then, formation of a pattern, formation of a plated shaped article and evaluations were carried out in the same manner as in Example 1. The evaluation results are set forth in Table 3.

### Example 10

A resin composition was prepared in the same manner as in Example 1, except that the components and the amounts thereof were changed to those shown in Example 10 of Table 2, and the polymer (A5) was used instead of the polymer (A1). Then, formation of a pattern, formation of a plated shaped article and evaluations were carried out in the same manner as in Example 1. The evaluation results are set forth in Table 3.

### Example 11

A resin composition was prepared in the same manner as in Example 1, except that the components and the amounts thereof were changed to those shown in Example 11 of Table 2, and the polymer (A6) was used instead of the polymer (A1). Then, formation of a pattern, formation of a plated shaped article and evaluations were carried out in the same manner as in Example 1. The evaluation results are set forth in Table 3.

### Example 12

A resin composition was prepared in the same manner as in Example 1, except that the components and the amounts thereof were changed to those shown in Example 12 of Table 2, and the polymer (A7) was used instead of the polymer (A1). Then, formation of a pattern, formation of a plated shaped article and evaluations were carried out in the same manner as in Example 1. The evaluation results are set forth in Table 3.

### Example 13

A resin composition was prepared in the same manner as in Example 1, except that the components and the amounts thereof were changed to those shown in Example 13 of Table 2, and the polymer (A8) was used instead of the polymer (A1). Then, formation of a pattern, formation of a plated shaped article and evaluations were carried out in the same manner as in Example 1. The evaluation results are set forth in Table 3.

### Example 14

A resin composition was prepared in the same manner as in Example 1, except that the components and the amounts thereof were changed to those shown in Example 14 of Table 2, and the polymer (A9) was used instead of the polymer (A1). Then, formation of a pattern, formation of a plated shaped article and evaluations were carried out in the same manner as in Example 1. The evaluation results are set forth in Table 3.

### Example 15

A resin composition was prepared in the same manner as in Example 1, except that the components and the amounts thereof were changed to those shown in Example 15 of Table 2, and the polymer (A10) was used instead of the polymer (A1). Then, formation of a pattern, formation of a plated shaped article and evaluations were carried out in the same manner as in Example 1. The evaluation results are set forth in Table 3.

### Example 16

In 150 parts by weight of propylene glycol monomethyl ether acetate (organic solvent (C2)), 100 parts by weight of the polymer (A11) and 3 parts by weight of 4,7-di-n-butoxynaphthyltetrahydrothiophenium trifluoromethanesulfonate (acid generator (B)) were dissolved, and the resulting solution was filtered through a Teflon (R) membrane filter having a pore diameter of 3 µm to prepare a resin composition. Then, formation of a pattern, formation of a plated shaped article and evaluations were carried out in the same manner as in Example 1. The evaluation results are set forth in Table 3.

### Example 17

A resin composition was prepared in the same manner as in Example 16, except that the components and the amounts thereof were changed to those shown in Example 17 of Table 2, and 2,4,6-tri(2-pyridyl)-s-triazine (acid diffusion controller (E)) was newly added in an amount of 0.05 part by weight based on 100 parts by weight of the polymer (A1). Then, formation of a pattern, formation of a plated shaped article and evaluations were carried out in the same manner as in Example 1. The evaluation results are set forth in Table 3.

### Example 18

A resin composition was prepared in the same manner as in Example 17, except that the components and the amounts thereof were changed to those shown in Example 18 of Table 2. Then, formation of a pattern, formation of a plated shaped article and evaluations were carried out in the same manner as in Example 1. The evaluation results are set forth in Table 3.

### Example 19

A resin composition was prepared in the same manner as in Example 17, except that the components and the amounts thereof were changed to those shown in Example 19 of Table 2. Then, formation of a pattern, formation of a plated shaped article and evaluations were carried out in the same manner as in Example 1. The evaluation results are set forth in Table 3.

### Example 20

A resin composition was prepared in the same manner as in Example 17, except that the components and the amounts thereof were changed to those shown in Example 20 of Table 2. Then, formation of a pattern, formation of a plated shaped article and evaluations were carried out in the same manner as in Example 1. The evaluation results are set forth in Table 3.

### Example 21

A resin composition was prepared in the same manner as in Example 17, except that the components and the amounts thereof were changed to those shown in Example 21 of Table 2. Then, formation of a pattern, formation of a plated shaped article and evaluations were carried out in the same manner as in Example 1. The evaluation results are set forth in Table 3.

### Example 22

A resin composition was prepared in the same manner as in Example 17, except that the components and the amounts thereof were changed to those shown in Example 22 of Table 2. Then, formation of a pattern, formation of a plated shaped article and evaluations were carried out in the same manner as in Example 1. The evaluation results are set forth in Table 3.

### Example 23

A resin composition was prepared in the same manner as in Example 17, except that the components and the amounts thereof were changed to those shown in Example 23 of Table 2. Then, formation of a pattern, formation of a plated shaped article and evaluations were carried out in the same manner as in Example 1. The evaluation results are set forth in Table 3.

### Example 24

A resin composition was prepared in the same manner as in Example 17, except that the components and the amounts thereof were changed to those shown in Example 24 of Table 2. Then, formation of a pattern, formation of a plated shaped article and evaluations were carried out in the same manner as in Example 1. The evaluation results are set forth in Table 3.

### Example 25

A resin composition was prepared in the same manner as in Example 17, except that the components and the amounts thereof were changed to those shown in Example 25 of Table 2. Then, formation of a pattern, formation of a plated shaped article and evaluations were carried out in the same manner as in Example 1. The evaluation results are set forth in Table 3.

### Example 26

A resin composition was prepared in the same manner as in Example 17, except that the components and the amounts thereof were changed to those shown in Example 26 of Table 2. Then, formation of a pattern, formation of a plated shaped article and evaluations were carried out in the same manner as in Example 1. The evaluation results are set forth in Table 3.

### Comparative Examples 1 to 3

Resin compositions were prepared in the same manner as in Example 1, except that the components and the amounts thereof were changed to those shown in Comparative Examples 1 to 3 of Table 2, and the polymer (R1) was used instead of the polymer (A1). Then, formation of a pattern, formation of a plated shaped article and evaluations were carried out in the same manner as in Example 1. The evaluation results are set forth in Table 3.

### Comparative Example 4

A resin composition was prepared in the same manner as in Example 1, except that the components and the amounts thereof were changed to those shown in Comparative Example 4 of Table 2, and the polymer (R2) was used instead of the polymer (A1). Then, formation of a pattern, formation of a plated shaped article and evaluations were carried out in the same manner as in Example 1. The evaluation results are set forth in Table 3.

### Comparative Example 5

A resin composition was prepared in the same manner as in Example 1, except that the components and the amounts thereof were changed to those shown in Comparative Example 5 of Table 2, and the polymer (R3) was used instead of the polymer (A1). Then, formation of a pattern, formation of a plated shaped article and evaluations were carried out in the same manner as in Example 1. The evaluation results are set forth in Table 3.

### Example 27

### Preparation of resin composition

In 100 parts by weight of propylene glycol monomethyl ether acetate (organic solvent (C2)), 100 parts by weight of the polymer (A21) and 3 parts by weight of 4,7-di-n-butoxynaphthyltetrahydrothiophenium trifluoromethanesulfonate (acid generator (B)) were dissolved, and the resulting solution was filtered through a Teflon (R) membrane filter having a pore diameter of 3 µm to prepare a resin composition.

### Preparation of copper sputtered substrate

On a silicon wafer substrate having a diameter of 4 inches, TiW was sputtered in a thickness of about 1,000 Å, and then copper was further sputtered thereon in a thickness of 3,000 Å to form a conductive layer. This substrate provided with the conductive layer is referred to as a "copper sputtered substrate" hereinafter.

### Formation of pattern

The copper sputtered substrate was coated with the resin composition by means of a spin coater. Thereafter, the copper sputtered substrate was heated on a hot plate at 130°C for 10 minutes to form a resin film having a thickness of 80 µm. Subsequently, the resin film was irradiated with ultraviolet light of 500 to 2000 mJ/cm² using an extra-high pressure mercury lamp (OSRAM HBO, output: 1,000 W) through a pattern mask of a given shape. The quantity of light for exposure was confirmed by an illuminance meter (UV-M10 (illuminance meter, manufactured by ORC Manufacturing Co., Ltd.) to which a probe UV-35 (receptor) had been connected). After the exposure, PEB was carried out on a hot plate at 90°C for 5 minutes. Subsequently, the resin film was immersed in a 2.38 wt% tetramethylammonium hydroxide aqueous solution at room temperature for 1 to 5 minutes to develop the resin film, then washed with running water and subjected to nitrogen blowing to form a pattern. This substrate provided with the pattern is referred to as a "patterning substrate (B)" hereinafter.

### Formation of plated shaped article

The patterning substrate (B) was subjected to ashing treatment with oxygen plasma (output: 100 W, oxygen flow rate: 100 ml, treating time: 1 minute) as pretreatment for electroplating, to make the patterning substrate hydrophilic. Subsequently, the substrate was immersed in 1 liter of a copper plating solution (available from Electroplating Engineers of Japan Ltd., trade name: Microfab Cu200) and subjected to electroplating for about 90 minutes under the conditions of a plating bath temperature of 25°C and a current density of 3.0 A/dm² to form a plated shaped article for a bump having a thickness of about 60 µm. Then, the substrate was washed with running water and blown by a nitrogen gas to dry it. Thereafter, the substrate was immersed in N-methylpyrrolidone at room temperature for 5 minutes to strip the resin film portion, and then a portion of the conductive layer on the substrate other than the region where the plated shaped article had been formed was removed by wet etching to obtain a substrate having a plated shaped article. This substrate having the plated shaped article is referred to as a "plated substrate (B)" hereinafter.

### Evaluation

### (1) Sensitivity

A quantity of light for exposure, by which a dimension of a bottom of a removed pattern becomes 75 µm when a square pattern of 75 µm × 75 µm in a mask design dimension is formed on a copper sputtered substrate, was taken as an optimum quantity of light for exposure, and the sensitivity was evaluated by this optimum quantity of light for exposure. A case where the quantity of light for exposure was not less than 3,000 mJ/cm² was evaluated as "BB", and the subsequent evaluations were discontinued.

### (2) Resolution

The patterning substrate (B) provided with a square pattern of 50 µm × 50 µm in a mask design dimension was observed by a scanning electron microscope, and the resolution was evaluated by the resolved image of the square pattern. A case where the pattern was resolved without a residue of a resist and the resolved image had a sidewall angle of 80 to 90° was evaluated as "AA", and a case other than this case was evaluated as "BB".

### (3) Abnormality of pattern shape

The patterning substrate (B) provided with a square pattern of 75 µm × 75 µm in a mask design dimension was observed by a scanning electron microscope to evaluate abnormality of pattern shape. The evaluation was carried out using 5 patterns, that is, a square pattern of 75 µm × 75 µm present near the center of the substrate as a reference, two patterns each of which is present at a distance of about 2 cm from the reference pattern in the direction of each end of the substrate and two patterns each of which is present at a distance of about 4 cm. A case where the sidewall angles of all the patterns were the same as one another was evaluated as "AA", and a case where at least one of them was different was evaluated as "BB".

### (4) Wettability by plating solution

The plated substrate (B) obtained by plating the patterning substrate (B) provided with a square pattern of 75 µm × 75 µm in a mask design dimension was observed by a light microscope to evaluate wettability by a plating solution. The evaluation was carried out based on the criteria that the surface of the patterning substrate (B) has affinity for a plating solution and no plating defect occurs because air bubbles inside the pattern are completely removed. A case where any plating defect was not present at all in the plated substrate (B) or plating defects were present in patterns of less than 5% only based on 7000 patterns observed was evaluated as "AA", and a case where plating defects were present in patterns of not less than 5% based on 7000 patterns observed was evaluated as "BB".

### (5) Plating solution resistance

The plated substrate (B) obtained by plating the patterning substrate (B) provided with a square pattern of 75 µm × 75 µm in a mask design dimension was observed by a light microscope to evaluate plating resistance. The evaluation was carried out based on the criteria that the shape of the plated portion after stripping has been transferred from the shape of the resist pattern, that is, the bump width is not more than 103% of the resist pattern and deposition does not occur at the resist opening because the plating solution does not come out from the opening. A case where these two requirements were satisfied was evaluated as "AA", and a case where these two requirements were not satisfied was evaluated as "BB".

The evaluation results are set forth in Table 4.

### Example 28

A resin composition was prepared in the same manner as in Example 27, except that the components and the amounts thereof were changed to those shown in Example 28 of Table 2, and 4,4'-[1-[4-[2-(4-hydroxyphenyl)-2-propyl]phenyl]ethylidene]bisphenol (additive (F), available from Sanbo Chemical Co., Ltd.) was newly added in an amount of 10 parts by weight based on 90 parts by weight of the polymer (A21). Then, formation of a pattern, formation of a plated shaped article and evaluations were carried out in the same manner as in Example 27. The evaluation results are set forth in Table 4.

### Example 29

A resin composition was prepared in the same manner as in Example 28, except that the components and the amounts thereof were changed to those shown in Example 29 of Table 2. Then, formation of a pattern, formation of a plated shaped article and evaluations were carried out in the same manner as in Example 27. The evaluation results are set forth in Table 4.

### Example 30

A resin composition was prepared in the same manner as in Example 28, except that the components and the amounts thereof were changed to those shown in Example 30 of Table 2. Then, formation of a pattern, formation of a plated shaped article and evaluations were carried out in the same manner as in Example 27. The evaluation results are set forth in Table 4.

### Example 31

A resin composition was prepared in the same manner as in Example 28, except that the components and the amounts thereof were changed to those shown in Example 31 of Table 2. Then, formation of a pattern, formation of a plated shaped article and evaluations were carried out in the same manner as in Example 27. The evaluation results are set forth in Table 4.

### Example 32

A resin composition was prepared in the same manner as in Example 28, except that the components and the amounts thereof were changed to those shown in Example 32 of Table 2. Then, formation of a pattern, formation of a plated shaped article and evaluations were carried out in the same manner as in Example 27. The evaluation results are set forth in Table 4.

### Example 33

A resin composition was prepared in the same manner as in Example 28, except that the components and the amounts thereof were changed to those shown in Example 33 of Table 2. Then, formation of a pattern, formation of a plated shaped article and evaluations were carried out in the same manner as in Example 27. The evaluation results are set forth in Table 4.

### Comparative Example 6

A resin composition was prepared in the same manner as in Example 27, except that the components and the amounts thereof were changed to those shown in Comparative Example 6 of Table 2, and the polymer (R1) was used instead of the polymer (A1). Then, formation of a pattern, formation of a plated shaped article and evaluations were carried out in the same manner as in Example 27. The evaluation results are set forth in Table 4.

**Table 1**

| Copolymer | Component | | | | | | | | | | | |
|---|---|---|---|---|---|---|---|---|---|---|---|---|
| | a | b | c | d | e | f | g | h | i | i' | j | j' |
| A1 | 20 | | | 20 | | 20 | 10 | | | 30 | | |
| A2 | 15 | | | 20 | | 20 | | | | 45 | | |
| A3 | 10 | | | 20 | | 20 | | | 50 | | | |
| A4 | 5 | | | 20 | | 20 | | | 55 | | | |
| A5 | 20 | | | 20 | | 30 | | | | 30 | | |
| A6 | 20 | | | 30 | | 20 | | | 30 | | | |
| A7 | | 20 | | 20 | | 10 | | | 50 | | | |
| A8 | | 15 | | 20 | | 25 | | | 40 | | | |
| A9 | | 10 | | 20 | | 30 | | | 40 | | | |
| A10 | 20 | | | | 5 | 20 | | | | 55 | | |
| A11 | | | 40 | 5 | | 5 | | 20 | | | 30 | |
| A12 | | | 30 | 5 | | 10 | | 25 | | | 30 | |
| A13 | | | 30 | 10 | | 5 | | 25 | | | 30 | |
| A14 | | | 40 | 5 | | 5 | 20 | | | | 30 | |
| A15 | | | 40 | 5 | | 5 | | 20 | | | | 30 |
| A16 | 10 | | 30 | 5 | | | | 25 | | | 30 | |
| A17 | 10 | | 30 | 10 | | | | 20 | | | 30 | |
| A18 | 10 | | 20 | 10 | | | | 30 | | | 30 | |
| A19 | 10 | | 30 | 5 | | | 25 | | | | 30 | |
| A20 | 10 | | 30 | 5 | | | | 25 | | | | 30 |
| A21 | 10 | | | 30 | | | | | 60 | | | |
| A22 | 10 | | | 40 | | | | | 50 | | | |
| A23 | 10 | | | 30 | | 5 | | | 55 | | | |
| A24 | 10 | | | 30 | | 10 | | | 50 | | | |
| A25 | 20 | | | 30 | | 10 | | | 40 | | | |
| R1 | | | | 30 | | 20 | | | 50 | | | |
| R2 | | | | 20 | 5 | 25 | | | 50 | | | |
| R3 | | | | 10 | 10 | 20 | 10 | | 50 | | | |

| | | | | | | | | | | | | |
|---|---|---|---|---|---|---|---|---|---|---|---|---|
| a: p-hydroxyphenyl methacrylamide b: 3,5-dimethyl-4-hydroxybenzyl acrylate c: 4-hydroxyphenyl methacrylate d: p-isopropenylphenol e: methacrylic acid f: 2-hydroxyethyl acrylate g: isobornyl acrylate h: benzyl acrylate i: 2-benzyl-2-propyl acrylate i': 2-benzyl-2-propyl methacrylate j: t-butyl acrylate j': t-butyl methacrylate | | | | | | | | | | | | |

**Table 2**

| | Polymer (A) | Polymer (D) | Acid generator (B) | Acid diffusion controller | Additive | Organic solvent |
|---|---|---|---|---|---|---|
| | (part(s)) | (part(s)) | (part(s)) | (part(s)) | (part(s)) | (part(s)) |
| Ex. 1 | A1(100) | D1(20) | B(3) | | | C1(150) |
| Ex. 2 | A1(100) | D1(30) | B(3) | | | C1(150) |
| Ex. 3 | A1(100) | D1(20) | B(3) | E1(0.05) | | C1(150) |
| Ex. 4 | A1(100) | D1(20) | B(3) | E1(0.10) | | C1(150) |
| Ex. 5 | A1(100) | D2(20) | B(3) | E1(0.05) | - | C1(150) |
| Ex. 6 | A1(100) | D3(20) | B(3) | E1(0.05) | - | C1(150) |
| Ex. 7 | A2(100) | D1(20) | B(3) | - | - | C1(150) |
| Ex. 8 | A3(100) | D1(20) | B(3) | - | - | C1(150) |
| Ex. 9 | A4(100) | D1(20) | B(3) | - | - | C1(150) |
| Ex. 10 | A5(100) | D1(20) | B(3) | - | - | C1(150) |
| Ex. 11 | A6(100) | D1(20) | B(3) | - | - | C1(150) |
| Ex. 12 | A7(100) | D1(20) | B(3) | - | - | C1(150) |
| Ex. 13 | A8(100) | D1(20) | B(3) | - | - | C1(150) |
| Ex. 14 | A9(100) | D1(20) | B(3) | - | - | C1(150) |
| Ex. 15 | A10(100) | D1(20) | B(3) | - | - | C1(150) |
| Ex. 16 | A11(100) | - | B(3) | - | - | C2(150) |
| Ex. 17 | A11(100) | - | B(3) | E(0.05) | - | C2(150) |
| Ex. 18 | A12(100) | - | B(3) | E(0.05) | - | C2(150) |
| Ex. 19 | A13(100) | - | B(3) | E(0.05) | - | C2(150) |
| Ex. 20 | A14(100) | - | B(3) | E(0.05) | - | C2(150) |
| Ex. 21 | A15(100) | - | B(3) | E(0.05) | - | C2(150) |
| Ex. 22 | A16(100) | - | B(3) | E(0.05) | - | C2(150) |
| Ex. 23 | A17(100) | - | B(3) | E(0.05) | - | C2(150) |
| Ex. 24 | A18(100) | - | B(3) | E(0.05) | - | C2(150) |
| Ex. 25 | A19(100) | - | B(3) | E(0.05) | - | C2(150) |
| Ex. 26 | A20(100) | - | B(3) | E(0.05) | - | C2(150) |
| Ex. 27 | A21(100) | - | B(3) | - | - | C2(100) |
| Ex. 28 | A21(90) | - | B(3) | - | F(10) | C2(100) |
| Ex. 29 | A21(80) | - | B(3) | - | F(20) | C2(100) |
| Ex. 30 | A22(80) | - | B(3) | - | F(20) | C2(100) |
| Ex. 31 | A23(80) | - | B(3) | - | F(20) | C2(100) |
| Ex. 32 | A24(80) | - | B(3) | - | F(20) | C2(100) |
| Ex. 33 | A25(80) | - | B(3) | - | F(20) | C2(100) |
| Comp. Ex. 1 | R1(100) | B1(20) | B(3) | - | - | C1(150) |
| Comp. Ex. 2 | R1(100) | B1(30) | B(3) | - | - | C1(150) |
| Comp. Ex. 3 | R1(100) | B2(20) | B(3) | - | - | C1(150) |
| Comp. Ex. 4 | R2(100) | B1(20) | B(3) | - | - | C1(150) |
| Comp. Ex. 5 | R3(100) | B1(20) | B(3) | - | - | C1(150) |
| Comp. Ex. 6 | R1(100) | - | B(3) | - | - | C1(150) |

| | | | | | | |
|---|---|---|---|---|---|---|
| Polymer (D) D3: polyvinyl methyl ether Acid generator B: 4,7-di-n-butoxynaphthyltetrahydrothiophenium trifluoromethanesulfonate Acid diffusion controller E: 2,4,6-tri(2-pyridyl)-s-triazine Additive F: 4,4'-[1-[4-[2-(4-hydroxyphenyl)-2-propyl]phenyl]ethylidene]bisphenol Organic solvent C1: ethyl lactate, C2: propylene glycol monomethyl ether acetate | | | | | | |

**Table 3**

| | Sensitivity (mJ/cm²) | Resolution | Dimensional fidelity of pattern Wt/Wb (µm) | Crack resistance | Shape of plated portion | | Dimensional fidelity of plated portion Wt/Wb (µm) |
|---|---|---|---|---|---|---|---|
| Ex. 1 | 400 | AA | 30.1 / 29.7 | AA | AA | AA | 30.8 / 30.5 |
| Ex. 2 | 400 | AA | 30.3 / 29.7 | AA | AA | AA | 31.5 / 30.9 |
| Ex. 3 | 500 | AA | 30.4 / 29.5 | AA | AA | AA | 30.8 / 30.3 |
| Ex. 4 | 600 | AA | 31.1 / 29.8 | AA | AA | AA | 31.4 / 30.2 |
| Ex. 5 | 400 | AA | 31.3 / 30.0 | AA | AA | AA | 31.5 / 30.2 |
| Ex. 6 | 400 | AA | 31.5 / 29.4 | AA | AA | AA | 32.9 / 31.2 |
| Ex. 7 | 400 | AA | 30.3 / 29.1 | AA | AA | AA | 30.5 / 29.6 |
| Ex. 8 | 300 | AA | 31.1 / 28.8 | AA | BB | AA | 31.9 / 29.6 |
| Ex. 9 | 300 | AA | 31.4 / 29.4 | AA | BB | AA | 31.4 / 29.8 |
| Ex. 10 | 400 | AA | 30.6 / 29.7 | AA | AA | AA | 30.4 / 30.4 |
| Ex. 11 | 400 | AA | 31.1 / 30.2 | AA | AA | AA | 31.6 / 30.8 |
| Ex. 12 | 1000 | AA | 31.5 / 30.4 | AA | AA | AA | 31.4 / 31.0 |
| Ex. 13 | 1500 | AA | 29.6 / 29.8 | AA | AA | AA | 30.0 / 30.6 |
| Ex. 14 | 2000 | AA | 30.0 / 29.5 | AA | BB | AA | 31.0 / 30.6 |
| Ex. 15 | 1000 | BB | 30.5 / 29.1 | AA | AA | AA | 30.8 / 30.1 |
| Ex. 16 | 250 | AA | 29.5 / 29.9 | AA | AA | AA | 30.0 / 30.3 |
| Ex. 17 | 300 | AA | 29.0 / 30.1 | AA | AA | AA | 29.8 / 30.4 |
| Ex. 18 | 300 | AA | 30.2 / 30.1 | AA | AA | AA | 30.4 / 30.4 |
| Ex. 19 | 350 | AA | 30.6 / 29.8 | AA | AA | AA | 30.2 / 30.0 |
| Ex. 20 | 450 | AA | 31.3 / 29.7 | AA | AA | AA | 30.8 / 30.0 |
| Ex. 21 | 450 | AA | 30.3 / 29.7 | AA | AA | AA | 30.3 / 29.7 |
| Ex. 22 | 500 | AA | 31.0 / 30.5 | AA | AA | AA | 30.1 / 30.7 |
| Ex. 23 | 450 | AA | 29.7 / 29.1 | AA | AA | AA | 29.1 / 29.8 |
| Ex. 24 | 500 | AA | 28.0 / 30.1 | AA | AA | AA | 28.1 / 30.1 |
| Ex. 25 | 600 | AA | 29.1 / 31.1 | AA | AA | AA | 30.1 / 31.6 |
| Ex. 25 | 600 | AA | 30.4 / 31.0 | AA | AA | AA | 30.4 / 31.0 |
| Comp. Ex. 1 | 300 | AA | 30.6 / 29.4 | AA | BB | BB | 31.8 / 31.1 |
| Comp. Ex. 2 | 300 | BB | 30.6 / 29.2 | AA | BB | BB | 31.2 / 30.8 |
| Comp. Ex. 3 | 300 | AA | 31.1 / 30.2 | AA | BB | BB | 31.2 / 31.8 |
| Comp. Ex. 4 | 400 | AA | 31.2 / 30.6 | BB | BB | BB | 32.0 / 31.8 |
| Comp. Ex. 5 | 500 | AA | 31.4 / 30.6 | BB | BB | BB | 32.0 / 31.8 |

**Table 4**

| | Sensitivity (mJ/cm²) | Resolution | Abnormality of pattern shape | Wettability by plating solution | Plating solution resistance |
|---|---|---|---|---|---|
| Ex. 27 | 2,000 | AA | AA | BB | AA |
| Ex. 28 | 1,800 | AA | AA | BB | AA |
| Ex. 29 | 1,500 | AA | AA | BB | AA |
| Ex. 30 | 1,300 | AA | AA | AA | AA |
| Ex. 31 | 1,000 | AA | AA | AA | AA |
| Ex. 32 | 800 | AA | AA | AA | AA |
| Ex. 33 | 1,500 | AA | AA | AA | AA |
| Comp. Ex. 6 | BB | - | - | - | - |

## Claims

1. A positive radiation-sensitive resin composition comprising:
(A) a polymer containing structural units (a) represented by the following formula(1), an acid-dissociable functional group (b), and structural units obtained by aromatic vinyl compounds, 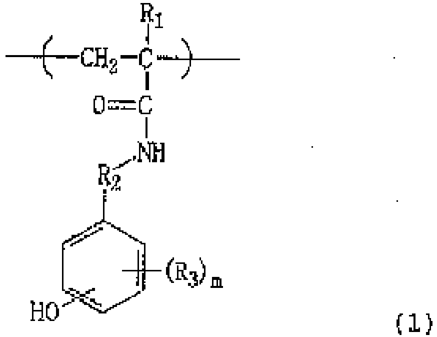 wherein R₁ is a hydrogen atom or a methyl group, R₂ is -(CH₂)ₙ-, n is an integer of 0 to 3, R₃ is an alkyl group of 1 to 4 carbon atoms, and m is an integer of 0 to 4,
(B) a component which generates an acid by irradiation with radiation, and
(C) an organic solvent.

2. The positive radiation-sensitive resin composition as claimed in claim 1, wherein the acid-dissociable functional group (b) is represented by the following formula (3): 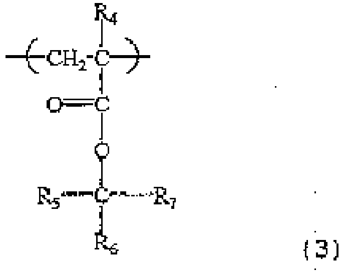 wherein R₄ is a hydrogen atom or a methyl group, R₅ to R₇ are each an alkyl group of 1 to 4 carbon atoms, an alicyclic hydrocarbon group of 4 to 20 carbon atoms, an aromatic group or a substituted hydrocarbon group wherein at least one hydrogen atom in any one of these hydrocarbon groups is replaced with a polar group other than a hydrocarbon group R₅ to R₇ may be the same or different, and when any two of R₅ to R₇ are alkyl groups or substituted alkyl groups, their alkyl chains may be bonded to each other to form an alicyclic hydrocarbon group of 4 to 20 carbon atoms or a substituted alicyclic hydrocarbon group.

3. The positive radiation-sensitive resin composition as claimed in claim 1, which is a composition for producing a plated shaped article.

4. The positive radiation-sensitive resin composition as claimed in claim 3, wherein the plated shaped article is a bump.

5. The positive radiation-sensitive resin composition as claimed in claim 1, wherein the component (B) is contained in an amount of 0.1 to 20 parts by weight based on 100 parts by weight of the component (A), and the component (C) is contained in an amount of 20 to 80 parts by weight based on the total weight 100 parts by weight of the positive radiation-sensitive resin composition.

6. The positive radiation-sensitive resin composition as claimed in claim 1, which further comprises an alkalisoluble resin other than the polymer (A).

7. The positive radiation-sensitive resin composition as claimed in claim 1, which further comprises an acid diffusion controller.

8. The positive radiation-sensitive resin composition as claimed in claim 1, wherein the component (B) is at least one compound selected from the group consisting of 4-t-butylphenyl diphenylsulfonium trifluoromethanesulfonate, 4-t-butylphenyl diphenylsulfonium perfluoro-n-octanesulfonate, 4-t-butylphenyl diphenylsulfonium pyrenesulfonate and 4,7-di-n-butoxynaphthyltetrahydrothiophenium trifluoromethanesulfonate.

9. The positive radiation-sensitive resin composition as claimed in claim 1, wherein the aromatic vinyl compound is at least one of selected from o-hydroxystyrene, m-hydroxystyrene, p- hydroxystyrene, p-isopropenylphenol, styrene, α-methylstyrene, p-methylstyrene and p-methoxystyrene.

10. A transfer film having a resin film composed of the positive radiation-sensitive resin composition of claim 1 on a support film.

11. The transfer film as claimed in claim 10, wherein the resin film has a film thickness of 20 to 100 µm.

12. A process for producing a plated shaped article, comprising:
(1) a step of forming a resin film composed of the positive radiation-sensitive resin composition of claim 1 on a wafer having a barrier metal layer,
(2) a step of exposing the resin film and then developing the resin film to form a pattern,
(3) a step of depositing an electrode material by electroplating using the pattern as a mold, and
(4) a step of stripping the remaining resin film and then removing the barrier metal by etching.

## Patentansprüche

1. Positive strahlungsempfindliche Harzzusammensetzung umfassend:
(A) ein Polymer enthaltend durch die folgende Formel (1) dargestellte strukturelle Einheiten (a), eine säurefreisetzbare funktionelle Gruppe (b), und durch aromatische Vinylverbindungen erhaltene strukturelle Einheiten, 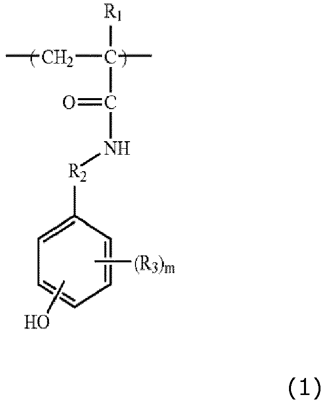 wobei R₁ ein Wasserstoffatom oder eine Methylgruppe ist, R₂ -(CH₂)ₙ- ist, n eine ganze Zahl von 0 bis 3 ist, R₃ eine Alkylgruppe mit 1 bis 4 Kohlenstoffatomen ist, und m eine ganze Zahl von 0 bis 4 ist,
(B) eine Verbindung, welche eine Säure durch Bestrahlung mit Strahlung erzeugt, und
(C) ein organisches Lösungsmittel.

2. Positive strahlungsempfindliche Harzzusammensetzung nach Anspruch 1, wobei die säurefreisetzbare funktionale Gruppe (b) durch die folgende Formel (3) dargestellt ist: 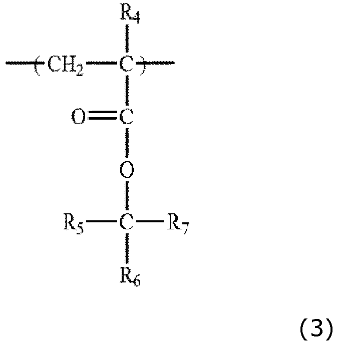 wobei R₄ ein Wasserstoffatom oder eine Methylgruppe ist, R₅ bis R₇ jeweils eine Alkylgruppe mit 1 bis 4 Kohlenstoffatomen, eine alizyklische Kohlenwasserstoffgruppe mit 4 bis 20 Kohlenstoffatomen, eine aromatische Gruppe oder eine substituierte Kohlenwasserstoffgruppe sind, wobei zumindest ein Wasserstoffatom in einer dieser Kohlenwasserstoffgruppen durch eine polare Gruppe anders als eine Kohlenwasserstoffgruppe ersetzt ist, R₅ bis R₇ können gleich sein oder unterschiedlich, und wenn beliebige zwei von R₅ bis R₇ Alkylgruppen oder substituierte Alkylgruppen sind, können ihre Alkylgruppen miteinander gebunden sein, um eine alizyklische Kohlenwasserstoffgruppe mit 4 bis 20 Kohlenstoffatomen oder eine substituierte alizyklische Kohlenwasserstoffgruppe zu bilden.

3. Positive strahlungsempfindliche Harzzusammensetzung nach Anspruch 1, welche eine Zusammensetzung zum Herstellen eines plattenförmigen Gegenstands ist.

4. Positive strahlungsempfindliche Harzzusammensetzung nach Anspruch 3, wobei der plattenförmige Gegenstand eine Erhebung ist.

5. Positive strahlungsempfindliche Harzzusammensetzung nach Anspruch 1, wobei der Bestandteil (B) in einer Menge von 0,1 bis 20 Gew.-Teile basierend auf 100 Gew.-Teile der Verbindung (A) enthalten ist, und der Bestandteil (C) in einer Menge von 20 bis 80 Gew.-Teile basierend auf dem Gesamtgewicht von 100 Gew.-Teile der positiven strahlungsempfindlichen Harzzusammensetzung enthalten ist.

6. Positive strahlungsempfindliche Harzzusammensetzung nach Anspruch 1, welche ferner ein Alkali-lösliches Harz anders als das Polymer (A) umfasst.

7. Positive strahlungsempfindliche Harzzusammensetzung nach Anspruch 1, welche ferner eine Säurediffusionssteuereinrichtung umfasst.

8. Positive strahlungsempfindliche Harzzusammensetzung nach Anspruch 1, wobei der Bestandteil (B) zumindest eine Verbindung ausgewählt aus der Gruppe bestehend aus 4-t-Butylphenyldiphenylsulfoniumtrifluoromethansulfonat, 4-t-Butylphenyldiphenylsulfoniumperfluor-n-Octansulfonat, 4-t-Butylphenyldiphenylsulfoniumpyrensulfonat und 4,7-Di-n-Butoxynaphthyltetrahydrothiophentrifluoromethansulfonat ist.

9. Positive strahlungsempfindliche Harzzusammensetzung nach Anspruch 1, wobei die aromatische Vinylverbindung zumindest eine ausgewählt aus o-Hydroxystyrol, m-Hydroxystyrol, p-Hydroxystyrol, p-Isopropenylphenol, Styrol, a-Methylstyrol, p-Methylstyrol und p-Methoxystyrol ist.

10. Übertragungsfilm aufweisend einen Harzfilm bestehend aus der positiven strahlungsempfindlichen Harzzusammensetzung nach Anspruch 1 auf einem Trägerfilm.

11. Übertragungsfilm nach Anspruch 10, wobei der Harzfilm eine Filmdicke von 20 bis 100 µm aufweist.

12. Verfahren zum Herstellen eines plattenförmigen Gegenstands, umfassend:
(1) einen Schritt des Bildens eines Harzfilms bestehend aus der positiven strahlungsempfindlichen Harzzusammensetzung nach Anspruch 1 auf einem Wafer mit einer Barrieremetallschicht,
(2) einen Schritt des Aussetzens des Harzfilms und dann Entwickeln des Harzfilms, um ein Muster zu bilden,
(3) einen Schritt des Ablagerns eines Elektrodenmaterials durch Galvanisierung verwendend das Muster als eine Form, und
(4) einen Schritt des Ablösens des verbleibenden Harzfilms und dann Entfernen des Barrieremetalls durch Ätzen.

## Revendications

1. Composition de résine sensible au rayonnement positive comprenant :
(A) un polymère contenant des motifs structuraux (a) représentés par la formule (1) suivante, un groupe fonctionnel dissociable en milieu acide (b), et des motifs structuraux obtenus par des composés vinyle aromatiques, 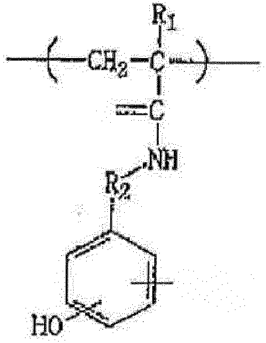 dans laquelle R₁ est un atome d'hydrogène ou un groupe méthyle, R₂ est - (CH₂)n-, n est un nombre entier de 0 à 3, R₃ est un groupe alkyle de 1 à 4 atomes de carbone, et m est un nombre entier de 0 à 4,
(B) un constituant qui génère un acide par irradiation avec un rayonnement, et
(C) un solvant organique.

2. Composition de résine sensible au rayonnement positive selon la revendication 1, dans laquelle le groupe fonctionnel dissociable en milieu acide (b) est représenté par la formule (3) suivante : 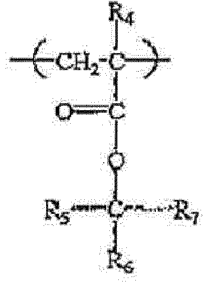 dans laquelle R₄ est un atome d'hydrogène ou un groupe méthyle, R₅ à R₇ sont chacun un groupe alkyle de 1 à 4 atomes de carbone, un groupe hydrocarboné alicyclique de 4 à 20 atomes de carbone, un groupe aromatique ou un groupe hydrocarboné substitué dans lequel au moins un atome d'hydrogène dans l'un quelconque de ces groupes hydrocarbonés est remplacé par un groupe polaire autre qu'un groupe hydrocarboné, R₅ à R₇ peuvent être identiques ou différents, et lorsque deux groupes quelconques parmi R₅ à R₇ sont des groupes alkyle ou des groupes alkyle substitués, leurs chaînes alkyle peuvent être liées l'une à l'autre pour former un groupe hydrocarboné alicyclique de 4 à 20 atomes de carbone ou un groupe hydrocarboné alicyclique substitué.

3. Composition de résine sensible au rayonnement positive selon la revendication 1, qui est une composition pour produire un article façonné plaqué.

4. Composition de résine sensible au rayonnement positive selon la revendication 3, dans laquelle l'article façonné plaqué est une protubérance.

5. Composition de résine sensible au rayonnement positive selon la revendication 1, dans laquelle le constituant (B) est contenu en une quantité de 0,1 à 20 parties en poids par rapport à 100 parties en poids du constituant (A), et le constituant (C) est contenu en une quantité de 20 à 80 parties en poids par rapport au poids total de 100 parties en poids de la composition de résine sensible au rayonnement positive.

6. Composition de résine sensible au rayonnement positive selon la revendication 1, qui comprend en outre une résine soluble dans les alcalis autre que le polymère (A) .

7. Composition de résine sensible au rayonnement positive selon la revendication 1, qui comprend en outre un contrôleur de diffusion d'acide.

8. Composition de résine sensible au rayonnement positive selon la revendication 1, dans laquelle le constituant (B) est au moins un composé choisi dans le groupe constitué par le trifluorométhanesulfonate de 4-t-butylphényl diphénylsulfonium, le perfluoro-n-octanesulfonate de 4-t-butylphényl diphénylsulfonium, le pyrènesulfonate de 4-t-butylphényl diphénylsulfonium et le trifluorométhanesulfonate de 4,7-di-n-butoxynaphtyltétrahydrothiophénium.

9. Composition de résine sensible au rayonnement positive selon la revendication 1, dans laquelle le composé vinyle aromatique est au moins un composé choisi parmi l'o-hydroxystyrène, le m-hydroxystyrène, le p-hydroxystyrène, le p-isopropénylphénol, le styrène, l'α-méthylstyrène, le p-méthylstyrène et le p-méthoxystyrène.

10. Film de transfert ayant un film de résine composé de la composition de résine sensible au rayonnement positive selon la revendication 1 sur un film support.

11. Film de transfert selon la revendication 10, dans lequel le film de résine a une épaisseur de film de 20 à 100 µm.

12. Procédé de production d'un article façonné plaqué, comprenant :
(1) une étape de formation d'un film de résine composé de la composition de résine sensible au rayonnement positive selon la revendication 1 sur une plaquette ayant une couche métallique formant barrière,
(2) une étape d'exposition du film de résine et ensuite de développement du film de résine pour former un motif,
(3) une étape de dépôt d'un matériau d'électrode par électrodéposition au moyen du motif en tant que moule, et
(4) une étape de décapage du film de résine restant et ensuite d'élimination du métal formant barrière par gravure.
